# EUROPEAN PATENT APPLICATION

(11) **EP 4 780 148 A1**
(43) Date of publication of application: **22.07.2026**
(21) Application number: 24864635.8
(22) Date of filing: 10.09.2024
(51) Int. Cl.: H05K 7/20

(54) **COOLING SYSTEM FOR DATA CENTER**

(30) Priority: 13.09.2023 CN 202311181548
(71) Applicant: Beijing Zitiao Network Technology Co., Ltd., Beijing 100190 (CN)
(72) Inventor: TIAN, Ting, Beijing 100028 (CN); JING, Tangbo, Beijing 100028 (CN); WANG, Jian, Beijing 100028 (CN)
(74) Representative: Grünecker Patent- und Rechtsanwälte PartG mbB
(86) International application number: PCT/CN2024/118097
(87) International publication number: WO 2025/055919

(57) **Abstract**

Embodiments of the present disclosure provide a cooling system for a data center, including a heat exchanger and an adsorption refrigeration assembly. The heat exchanger is configured to cool a first secondary-side coolant, and provide the cooled first secondary-side coolant to a device to be cooled. The adsorption refrigeration assembly is connected to the heat exchanger and is configured to: receive heated first secondary-side coolant from the device to be cooled, desorb at least one adsorption refrigeration module in the adsorption refrigeration assembly by using the heated first secondary-side coolant as a heat source, return the first secondary-side coolant to the heat exchanger, condense water vapor desorbed from the at least one adsorption refrigeration module into condensed water, and cool a second secondary-side coolant by using the condensed water and provide the cooled second secondary-side coolant to an air conditioning device.

## Description

The present application claims priority to Chinese Patent Application No. 202311181548.6, filed on September 13, 2023, and entitled "COOLING SYSTEM FOR DATA CENTER", which is incorporated herein by reference in its entirety.

### TECHNICAL FIELD

Embodiments of the present disclosure generally relate to the field of data center cooling technologies, and more particularly, to a cooling system for a data center.

### BACKGROUND

In recent years, increasing the supply water temperature of a cold source of a data center has become an important means for saving energy and reducing consumption. The higher the supply water temperature of the cold source, the greater the reduction in energy consumption and water consumption. A liquid cooling solution for the data center may directly use a high-temperature heat source for water supply, which may bring benefits of energy saving and consumption reduction to the data center. However, a considerable proportion of heat of the liquid-cooled server is usually still dissipated through an air cooling solution, that is, the heat is dissipated by a server fan. Depending on the air conditioning system of the data center, the water supply temperature of the air cooling solution usually requires a low-temperature heat source, which leads to high energy consumption and water consumption.

In addition, the data center usually needs to be planned and designed months or even years in advance, but the requirements of an actual business demand for the computing power and network are gradually iterated and clarified. Therefore, in the preliminary planning of the data center, there is often a contradiction that the layout and planning of the power density of the data center do not match the power density of a server package that will be actually launched in the future, especially when a coupling is established between a product form of an electronic device such as an IT device and the data center infrastructure. If the power density planned for the data center is too low, the data center cannot accommodate a high-power density server package in the future, and therefore only a small number of high-power density servers may be installed in each cabinet, which will result in a great waste of rack space. If the power density planned for the data center is too high, a large amount of HVAC capacity will be wasted, which is a great waste of initial investment.

In addition, when the high-power density server package is still in a development process, a server heat dissipation architecture may be an air cooling solution or a cold plate liquid cooling solution, and there may even be a situation where air cooling and cold plate liquid cooling coexist for a certain period of time for the same model, which will increase uncertainty in preliminary planning and design of the data center.

Therefore, it is very important for the data center how to reduce energy consumption and water consumption of the data center and how to design a data center infrastructure solution with high adaptability.

### SUMMARY

In an aspect of the present disclosure, there is provided a cooling system for a data center, including a heat exchanger and an adsorption refrigeration assembly. The heat exchanger is configured to cool a first secondary-side coolant, and provide the cooled first secondary-side coolant to a device to be cooled. The adsorption refrigeration assembly is connected to the heat exchanger and is configured to: receive heated first secondary-side coolant from the device to be cooled, desorb at least one adsorption refrigeration module in the adsorption refrigeration assembly by using the heated first secondary-side coolant as a heat source, return the first secondary-side coolant to the heat exchanger, condense water vapor desorbed from the at least one adsorption refrigeration module into condensed water, and cool a second secondary-side coolant by using the condensed water and provide the cooled second secondary-side coolant to an air conditioning device.

It should be understood that content described in this section is neither intended to identify key or essential features of the embodiments of the present disclosure, nor is it intended to limit the scope of the present disclosure. Other features of the present disclosure will be readily envisaged through the following description.

### BRIEF DESCRIPTION OF THE DRAWINGS

The above and other features, advantages and aspects of the embodiments of the present disclosure will become more apparent in combination with the drawings and with reference to the following detailed description. In the drawings, the same or similar reference symbols refer to the same or similar elements, where:
Fig. 1 shows a schematic structural diagram of a cooling system for a data center according to some embodiments of the present disclosure;
Fig. 2 shows a schematic structural diagram of an adsorption refrigeration assembly according to some embodiments of the present disclosure;
Fig. 3 shows a schematic structural diagram of a cooling system for a data center according to some embodiments of the present disclosure;
Fig. 4 shows a schematic structural diagram of a cooling system for a data center according to some embodiments of the present disclosure; and
Fig. 5 shows a schematic structural diagram of a cooling system for a data center according to some embodiments of the present disclosure.

### DETAILED DESCRIPTION OF EMBODIMENTS

Preferred embodiments of the present disclosure will be described in more detail below with reference to the drawings. Although the preferred embodiments of the present disclosure are shown in the drawings, it should be understood that the present disclosure may be implemented in various forms and should not be limited to the embodiments set forth herein. On the contrary, these embodiments are provided for a more thorough and complete understanding of the present disclosure, and the scope of the present disclosure may be fully conveyed to those skilled in the art.

As used herein, the term "include" and its variants represent open-ended inclusions, that is, "include but not limited to". Unless otherwise stated, the term "or" represents "and/or". The term "based on" represents "at least partially based on". The terms "an example embodiment" and "an embodiment" represent "at least one example embodiment". The term "another embodiment" represents "at least one another embodiment". The terms "first", "second", and the like may refer to different or same objects.

As described above, it is very important for the data center how to reduce energy consumption and water consumption of the data center and how to design a data center infrastructure solution with high adaptability.

The liquid cooling side of the liquid-cooled data center usually has a high supply water temperature, but a considerable proportion of heat still needs to be dissipated by an air conditioning system of the data center. In other words, a cooling system of the liquid-cooled data center usually includes a liquid cooling side part and an air cooling side part, which work together to cool electronic devices in a room of the data center. Since the heat transfer efficiency of the air cooling side is much lower than that of the liquid cooling side, the supply water temperature required by the air cooling side is generally low, and how to reduce the supply water temperature of the air cooling side of the liquid-cooled data center becomes the key to further saving energy and reducing consumption.

Due to different supply water temperatures of the air conditioning system and the liquid cooling system, the liquid-cooled data center often uses two sets of external cold sources to meet their heat dissipation requirements respectively, or uses the same set of external cold source and achieve the purpose of flexible distribution of a proportion of liquid cooling and air cooling by connecting the air cooling side and the liquid cooling side in series or in parallel and adding supplementary cooling to the air cooling side. The cooling solution using two sets of external cold sources does not have a function of flexible distribution of cooling amount proportion of liquid cooling and air cooling, and therefore the cooling solution often needs to be designed by fixing the cooling amount proportion in advance or over allocating the cooling amount on a certain side. The solution of sharing the same set of external cold source by connecting in series or in parallel may achieve flexible distribution, but it is often difficult in pipeline design, flow distribution and control, and the system complexity is high.

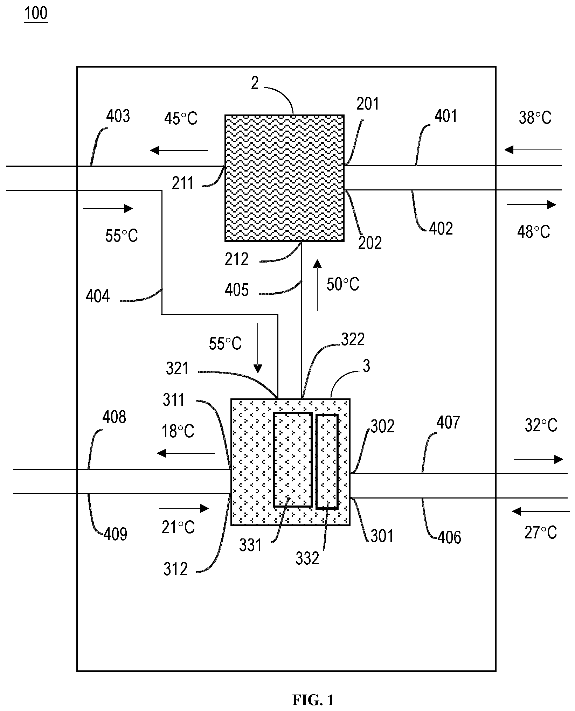

Embodiments of the present disclosure provide a cooling system for a data center that takes air-liquid compatibility as a starting point, integrates an adsorption refrigeration technology by using medium and high temperature cold sources, provides cooling at two gradients of high and low to the data center respectively, so as to meet a high temperature cooling demand of a liquid cooling system and a low temperature cooling demand of an air cooling system at the same time, and achieve air-liquid compatible dual-temperature heat exchange of the medium and high temperature cold sources with relatively low system complexity, energy consumption and water consumption. The principles of the present disclosure will be described in detail below with reference to Fig. 1 to Fig. 5.

Referring to Fig. 1 first, Fig. 1 shows a schematic structural diagram of a cooling system for a data center according to some embodiments of the present disclosure. As shown in Fig. 1, the cooling system 100 described herein generally includes a heat exchanger 2 and an adsorption refrigeration assembly 3. The heat exchanger 2 is used to provide a first secondary-side coolant to a device to be cooled (not shown) in the data center, and the first secondary-side coolant may directly flow through the device to be cooled, so as to take away heat generated by the device to be cooled, thus realizing cooling of the device. The device to be cooled is, for example, an IT device such as a server or a switch, or other types of heat-generating devices, which is not limited in the embodiments of the present disclosure. The adsorption refrigeration assembly 3 is used to provide a second secondary-side coolant to an air conditioning device (not shown), and the air conditioning device is used to provide air-cooling to the device to be cooled by using cooling amount provided by the second secondary-side coolant. The adsorption refrigeration assembly 3 may include a plurality of adsorption refrigeration modules, and the adsorption refrigeration modules may absorb heat when absorbing water, so as to reduce the temperature, and the adsorption refrigeration modules may desorb water when being heated to return to an initial state, so as to be reused for water absorption and cooling. In the embodiments of the present disclosure, desorbing water may also be referred to as desorption, which refers to separating water absorbed by the adsorption refrigeration module from the adsorption refrigeration module by heating. Since the first secondary-side coolant directly provides liquid-cooling to the device and the second secondary-side coolant provides air-cooling via the air conditioning device, the temperature of the first secondary-side coolant may be higher, while the second secondary-side coolant needs a lower temperature.

In an embodiment, as shown in Fig. 1, the heat exchanger 2 includes a first cold source-side liquid supply port 201, a first cold source-side liquid return port 202, a first secondary-side liquid supply port 211, and a first secondary-side liquid return port 212. The first cold source-side liquid supply port 201 and the first cold source-side liquid return port 202 may be connected to a high-temperature external cold source (not shown) used as a cold source of a liquid cooling side via pipelines 401 and 402, so as to allow a first cold source-side coolant to circulate between a cold source side of the heat exchanger 2 and the high-temperature external cold source. The first cold source-side liquid supply port 201 may receive the first cold source-side coolant from the high-temperature external cold source via the pipeline 401. The first cold source-side liquid return port 202 may return the first cold source-side coolant to the high-temperature external cold source via the pipeline 402. The first secondary-side liquid supply port 211 may be connected to the device to be cooled, so as to provide the first secondary-side coolant to the device to be cooled, thus taking away heat generated by the device to be cooled during working. The heat exchanger 2 may allow the first cold source-side coolant to exchange heat with the first secondary-side coolant, so as to cool the first secondary-side coolant. As an example, the temperature of the first cold source-side coolant provided from the high-temperature external cold source to the heat exchanger 2 is, for example, 38°C. The temperature of the first cold source-side coolant will increase after exchanging heat with the first secondary-side coolant. For example, the temperature of the first cold source-side coolant returned from the heat exchanger 2 to the high-temperature external cold source may be 48°C. As an example, the temperature of the first secondary-side coolant returned to the heat exchanger 2 via the first secondary-side liquid return port 212 may be 50°C, and the temperature of the first secondary-side coolant provided to the device to be cooled via the pipeline 403 after being cooled by the heat exchanger 2 may be 45°C. Since the heat dissipation requirements may be met at a higher water temperature in the liquid cooling solution, the high-temperature external cold source may be directly used to cool electronic devices after undergoing a one-level heat exchange by the heat exchanger 2.

It should be noted that the numbers, values and the like mentioned above and possibly mentioned elsewhere in the present disclosure are illustratively and are not intended to limit the scope of the present disclosure in any way. Any other suitable numbers and values are also possible.

In some embodiments, the heat exchanger 2 may include a plate heat exchanger. In other embodiments, the heat exchanger 2 may include other types of heat exchangers, which all fall within the scope of the present disclosure.

As shown in Fig. 1, the adsorption refrigeration assembly 3 is connected to the heat exchanger 2 via a pipeline 405. The adsorption refrigeration assembly 3 may receive the heated first secondary-side coolant from the device to be cooled via a pipeline 404, and the temperature of the received first secondary-side coolant is, for example, 55°C. The adsorption refrigeration assembly 3 may desorb at least one adsorption refrigeration module in the adsorption refrigeration assembly 3 by using the heated first secondary-side coolant as a heat source. At this time, other adsorption refrigeration modules in the adsorption refrigeration assembly 3 may be in a state of water absorption and cooling. After flowing through the adsorption refrigeration assembly 3, the temperature of the first secondary-side coolant will decrease, for example, to 50°C. The adsorption refrigeration assembly 3 may return the first secondary-side coolant to the heat exchanger 2 via the pipeline 405, and then the first secondary-side coolant exchanges heat with the first cold source-side coolant in the heat exchanger 2, so as to realize cooling of the first secondary-side coolant, in order that the first secondary-side coolant may be recirculated to the device to be cooled.

In addition, the adsorption refrigeration assembly 3 may condense water vapor desorbed from the at least one adsorption refrigeration module into condensed water. Subsequently, the adsorption refrigeration assembly 3 may cool the second secondary-side coolant by using the condensed water and provide the cooled second secondary-side coolant to the air conditioning device via a pipeline 408. As an example, the temperature of the second secondary-side coolant provided by the adsorption refrigeration assembly 3 to the air conditioning device via the pipeline 408 is 18°C, and the temperature of the second secondary-side coolant returned from the air conditioning device to the adsorption refrigeration assembly 3 is 21°C.

The adsorption refrigeration assembly 3 may be connected to a medium-temperature external cold source (not shown) via pipelines 406 and 407, so as to receive a second cold source-side coolant from the medium-temperature external cold source via the pipeline 406 and return the second cold source-side coolant to the medium-temperature external cold source via the pipeline 407. The supply water temperature of the medium-temperature external cold source is lower than the supply water temperature of the high-temperature external cold source. Since the temperature of the second cold source-side coolant is relatively low, the second cold source-side coolant may be used to condense the water vapor desorbed from the at least one adsorption refrigeration module into condensed water. During this process, the temperature of the second cold source-side coolant will increase. As an example, the temperature of the second cold source-side coolant received from the medium-temperature external cold source via the pipeline 406 is 27°C, and the temperature of the second cold source-side coolant returned to the medium-temperature external cold source via the pipeline 407 may be 32°C. For ease of description, in the embodiments of the present disclosure, the medium-temperature external cold source may also be referred to as a first external cold source, and the high-temperature external cold source may be referred to as a second external cold source.

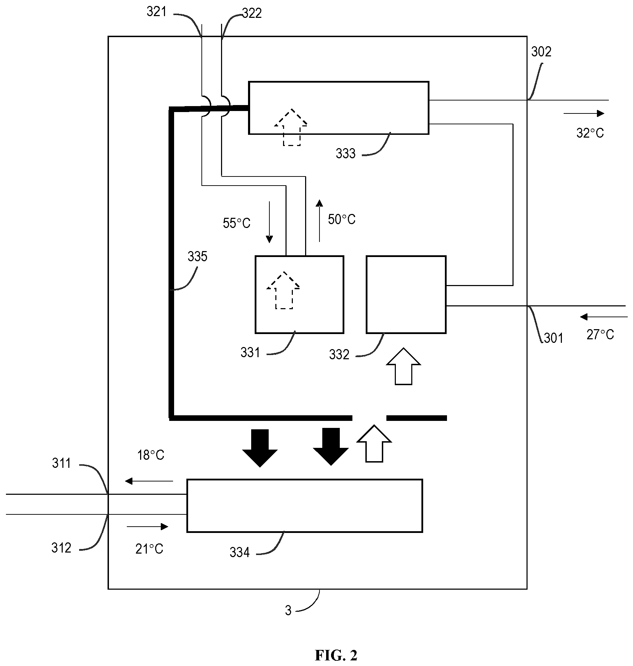

In some embodiments, the second cold source-side coolant may be further cooled in the adsorption refrigeration assembly 3, and then used to condense the water vapor desorbed from the at least one adsorption refrigeration module into condensed water, so as to achieve condensation more efficiently, which will be described in detail below with reference to Fig. 2.

In some embodiments, as shown in Fig. 1, the adsorption refrigeration assembly 3 includes a second cold source-side liquid supply port 301, a second cold source-side liquid return port 302, a second secondary-side liquid supply port 311, a second secondary-side liquid return port 312, a first desorption connection port 321, and a second desorption connection port 322.

The second cold source-side liquid supply port 301 and the second cold source-side liquid return port 302 may be connected to the medium-temperature external cold source via the pipelines 406 and 407, so as to allow the second cold source-side coolant to circulate between the adsorption refrigeration assembly 3 and the medium-temperature external cold source. The second cold source-side liquid supply port 301 may receive the second cold source-side coolant from the medium-temperature external cold source via the pipeline 406, and the temperature of the received second cold source-side coolant is, for example, 27°C. The second cold source-side liquid return port 302 may output the heated second cold source-side coolant to the medium-temperature external cold source via the pipeline 407, and the temperature of the output second cold source-side coolant is, for example, 32°C. Since the temperature of the second cold source-side coolant entering the adsorption refrigeration assembly 3 is relatively low, the water vapor desorbed from the at least one adsorption refrigeration module may be condensed into condensed water via a proper cooling unit.

The second secondary-side liquid supply port 311 and the second secondary-side liquid return port 312 may be connected to the air conditioning device via pipelines 408 and 409. The second secondary-side liquid supply port 311 may provide the cooled second secondary-side coolant to the air conditioning device via the pipeline 408, and the temperature of the provided second secondary-side coolant is, for example, 18°C. The second secondary-side liquid return port 312 may receive the heated second secondary-side coolant from the air conditioning device via the pipeline 409, and the temperature of the received second secondary-side coolant is, for example, 21°C. The heated second secondary-side coolant received from the air conditioning device via the pipeline 409 may be cooled again in the adsorption refrigeration assembly 3.

The first desorption connection port 321 may receive the heated first secondary-side coolant from the device to be cooled via the pipeline 404 and provide the first secondary-side coolant to the at least one adsorption refrigeration module, so as to desorb the at least one adsorption refrigeration module. The second desorption connection port 322 may be connected to the first secondary-side liquid return port 212 of the heat exchanger 2 via the pipeline 405, so as to return the first secondary-side coolant to the heat exchanger 2.

By using two different external cold sources and performing device-level processing, different gradients of supply water temperatures required for refrigeration on the liquid cooling side and the air cooling side may be fully utilized. In addition, by using adsorption refrigeration, the temperature of the external cold source required by the air conditioning device may be raised to the level of a medium-temperature cold source without using a low-temperature cold source, which significantly reduces energy consumption of the external cold source, and natural cooling may be realized in most regions. In addition, since the system internally adopts direct temperature gradient utilization on the liquid cooling side, the use of one-level heat exchanger and pump is reduced, and the heat dissipation efficiency may be improved and energy consumption may be reduced. In addition, by using such a cooling system, the data center may be flexibly deployed, which improves the flexibility of the preliminary planning of the data center and has a very wide range of adaptability to regions.

Fig. 2 shows a schematic structural diagram of the adsorption refrigeration assembly according to some embodiments of the present disclosure. In some embodiments, as shown in Fig. 1 and Fig. 2, the adsorption refrigeration assembly 3 includes a first adsorption refrigeration module 331 and a second adsorption refrigeration module 332, and the first adsorption refrigeration module 331 and the second adsorption refrigeration module 332 may be alternately connected to the first desorption connection port 321 and the second desorption connection port 322 via a valve, so as to be desorbed upon receiving the heated first secondary-side coolant via the pipeline 404 and return the first secondary-side coolant to the heat exchanger 2 via the pipeline 405. A coil (not shown) surrounded or coated by an adsorptive refrigerant may be disposed in the first adsorption refrigeration module 331 and the second adsorption refrigeration module 332 respectively. The adsorptive refrigerant may absorb heat when absorbing water, so as to cool the coolant in the coil. When the temperature of the coolant in the coil is relatively high, the adsorptive refrigerant may desorb water, so as to be reused for water absorption and cooling.

When the first adsorption refrigeration module 331 is connected to the first desorption connection port 321 and the second desorption connection port 322, the heated first secondary-side coolant may be used as a heat source to desorb the first adsorption refrigeration module 331. At this point, the second adsorption refrigeration module 332 may be connected to the second cold source-side liquid supply port 301 and adsorb water vapor to reduce the temperature, so as to further cool the second cold source-side coolant. The further cooled second cold source-side coolant may be used to condense water vapor desorbed from the first adsorption refrigeration module 331 into condensed water.

When the second adsorption refrigeration module 332 is connected to the first desorption connection port 321 and the second desorption connection port 322, the heated first secondary-side coolant may be used as a heat source to desorb the second adsorption refrigeration module 332. At this point, the first adsorption refrigeration module 331 may be connected to the second cold source-side liquid supply port 301 and adsorb water vapor to reduce the temperature, so as to further cool the second cold source-side coolant. The further cooled second cold source-side coolant may be used to condense water vapor desorbed from the second adsorption refrigeration module 332 into condensed water.

In some embodiments, as shown in Fig. 2, the adsorption refrigeration assembly 3 further includes a steam condensation module 333, an evaporative refrigeration module 334, and a guide tube 335. The steam condensation module 333 may receive the second cold source-side coolant further cooled by the adsorption module, so as to condense the water vapor desorbed from the first adsorption refrigeration module 331 or the second adsorption refrigeration module 332 into condensed water. For example, when the first adsorption refrigeration module 331 is connected to the first desorption connection port 321 and the second desorption connection port 322, the steam condensation module 333 may be connected to the second adsorption refrigeration module 332 to receive the second cold source-side coolant. When the second adsorption refrigeration module 332 is connected to the first desorption connection port 321 and the second desorption connection port 322, the steam condensation module 333 may be connected to the first adsorption refrigeration module 331 to receive the second cold source-side coolant. A coil (not shown) may be disposed in the steam condensation module 333, and the coil is used to receive the second secondary-side coolant and guide the second secondary-side coolant to the second cold source-side liquid return port 302. The water vapor desorbed from the first adsorption refrigeration module 331 or the second adsorption refrigeration module 332 will be condensed into condensed water when encountering the coil of the steam condensation module 333. The guide tube 335 is used to guide the condensed water to the evaporative refrigeration module 334. The evaporative refrigeration module 334 is used to cool the second secondary-side coolant by using the condensed water and provide the cooled second secondary-side coolant to the air conditioning device. A coil (not shown) may be disposed in the evaporative refrigeration module 334, and the coil is connected to the second secondary-side liquid supply port 311 and the second secondary-side liquid return port 312, and is used to guide the second secondary-side coolant. When the condensed water generated by the steam condensation module 333 encounters the coil of the evaporative refrigeration module 334, the second secondary-side coolant in the coil may be cooled, and part of the condensed water will evaporate to form steam, so as to be adsorbed again by the first adsorption refrigeration module 331 or the second adsorption refrigeration module 332.

In embodiments according to the present disclosure, in addition to the first adsorption refrigeration module 331 and the second adsorption refrigeration module 332, the adsorption refrigeration assembly 3 may include more adsorption refrigeration modules, and these adsorption refrigeration modules may be alternately desorbed and absorb water in a similar manner to the first adsorption refrigeration module 331 and the second adsorption refrigeration module 332. For example, at least one of the plurality of adsorption refrigeration modules may be connected to the first desorption connection port 321 and the second desorption connection port 322, so as to be desorbed upon receiving the heated first secondary-side coolant and return the first secondary-side coolant to the heat exchanger 2. At this point, the remaining adsorption refrigeration modules may be in a state of water absorption and cooling, so as to cool the second cold source-side coolant. Subsequently, by controlling the connection state of the plurality of adsorption refrigeration modules with the first desorption connection port 321 and the second desorption connection port 322 and the connection state of the plurality of adsorption refrigeration modules with the second cold source-side liquid supply port 301, the at least one adsorption refrigeration module originally in a desorption state may be changed to the state of water absorption and cooling, while the remaining adsorption refrigeration modules are changed to the desorption state. In this way, the plurality of adsorption refrigeration modules may alternately desorb water and absorb water.

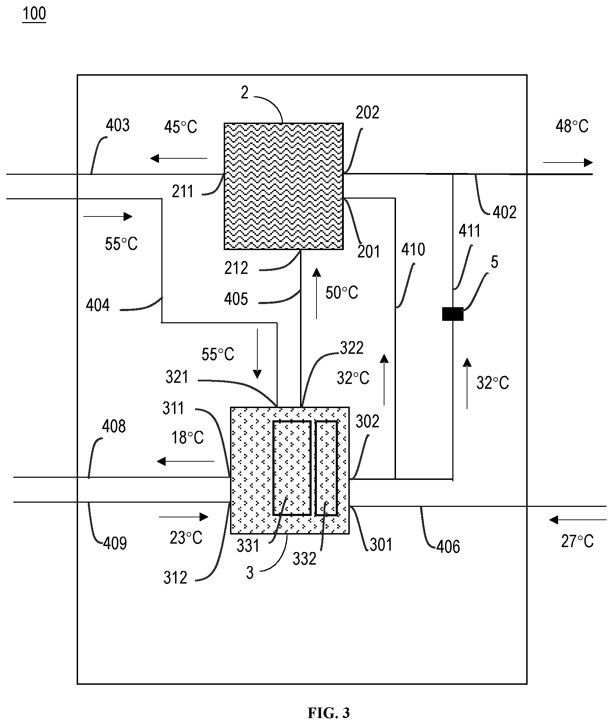

Other example embodiments of the cooling system 100 will be described below with reference to Fig. 3 to Fig. 5. The structure of the cooling system 100 shown in Fig. 3 to Fig. 5 is similar to the structure of the cooling system shown in Fig. 1. Only the differences between them will be described below, and the same parts will not be described again.

In some embodiments, as shown in Fig. 3, the heat exchanger 2 and the adsorption refrigeration assembly 3 are connected to a shared medium-temperature external cold source. At this point, the second cold source-side coolant in the adsorption refrigeration assembly 3 and the first cold source-side coolant in the heat exchanger 2 are the same coolant, which are both provided by the medium-temperature external cold source, and may be collectively referred to as a cold source-side coolant herein. Specifically, the second cold source-side liquid supply port 301 may receive the cold source-side coolant from the medium-temperature external cold source via the pipeline 406, and the cold source-side coolant may be used to condense water vapor desorbed from the at least one adsorption refrigeration module into condensed water due to its low temperature (for example, 27°C). The process of condensing the water vapor desorbed from the at least one adsorption refrigeration module is similar to embodiments described above with reference to Fig. 1 and Fig. 2, and will not be repeated here. The cold source-side coolant flowing out of the adsorption refrigeration assembly 3 via the second cold source-side liquid return port 302 may flow to the first cold source-side liquid supply port 201 via a pipeline 410, and enter into the heat exchanger 2 via the first cold source-side liquid supply port 201. The cold source-side coolant may exchange heat with the first secondary-side coolant in the heat exchanger 2, so as to cool the first secondary-side coolant. Subsequently, the cold source-side coolant may be returned to the medium-temperature external cold source via the pipeline 402.

In the embodiment shown in Fig. 3, a single external cold source may be used to provide the cold source-side coolant required by the adsorption refrigeration assembly 3 and the heat exchanger 2, which simplifies the pipeline system structure of the cold source side, thereby facilitating the unified design of the cold source side, the design flexibility is relatively high, and the initial investment of the data center is significantly reduced. In addition, such an embodiment fully utilizes the temperature gradient existing between the medium-temperature cold source required by the adsorption refrigeration assembly 3 and the cold source side of the heat exchanger 2, and effectively connects them in series to realize the comprehensive utilization of the cold source. In addition, such an embodiment is very suitable for regions where the medium-temperature cold source (with a typical temperature of, for example, 27°C) is easily available. The return liquid temperature of the medium-temperature cold source becomes high-temperature water after passing through the heat exchanger 2, so the outdoor cold source may run in a quite energy-saving manner all year round.

In some embodiments, as shown in Fig. 3, the cooling system 100 further includes a bypass valve 5. The bypass valve 5 is disposed in a pipeline 411, the pipeline 411 is connected between the second cold source-side liquid return port 302 and the pipeline 402, and the pipeline 402 is connected between the first cold source-side liquid return port 202 and the medium-temperature external cold source. In such an embodiment, by setting the bypass valve 5, appropriate distribution of the flow rate and cooling amount of the cold source-side coolant may be ensured.

Other structures of the cooling system 100 shown in Fig. 3 are similar to the structure of the cooling system 100 shown in Fig. 1, and will not be repeated here.

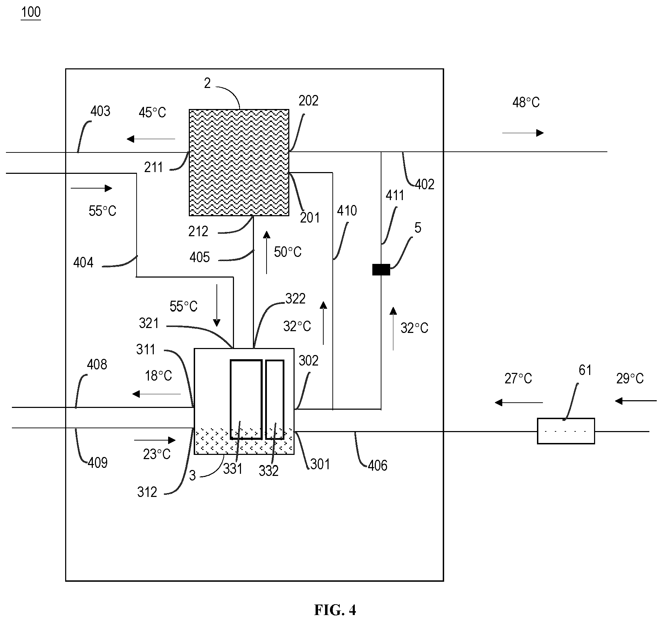

Common cold source forms of the medium-temperature external cold source are mainly dry coolers with or without spray, open or closed cooling towers, evaporative refrigeration units, etc., and these types of cold sources generally do not require mechanical refrigeration, so the minimum outlet water temperature often depends on the ambient wet bulb temperature. In this case, the availability of the medium-temperature cold source may be greatly challenged in extreme weather, and even the feasibility of the single external cold source solution may be affected in some regions with high wet bulb temperatures. Therefore, in some embodiments, as shown in Fig. 4, the cooling system 100 further includes a first supplementary cooling unit 61, and the first supplementary cooling unit 61 is connected between the medium-temperature external cold source and the second cold source-side liquid supply port 301 to supplement cooling to the cold source-side coolant, so as to cope with the situation that the external cold source cannot reach the temperature required by the medium-temperature cold source in extreme weather, thereby improving the adaptability of the solution in different regions. As an example, the temperature of the cold source-side coolant provided by the medium-temperature external cold source may be 29°C, and the temperature of the cold source-side coolant after supplementary cooling may be 27°C.

Other structures of the cooling system 100 shown in Fig. 4 are similar to the structure of the cooling system 100 shown in Fig. 3, and will not be repeated here.

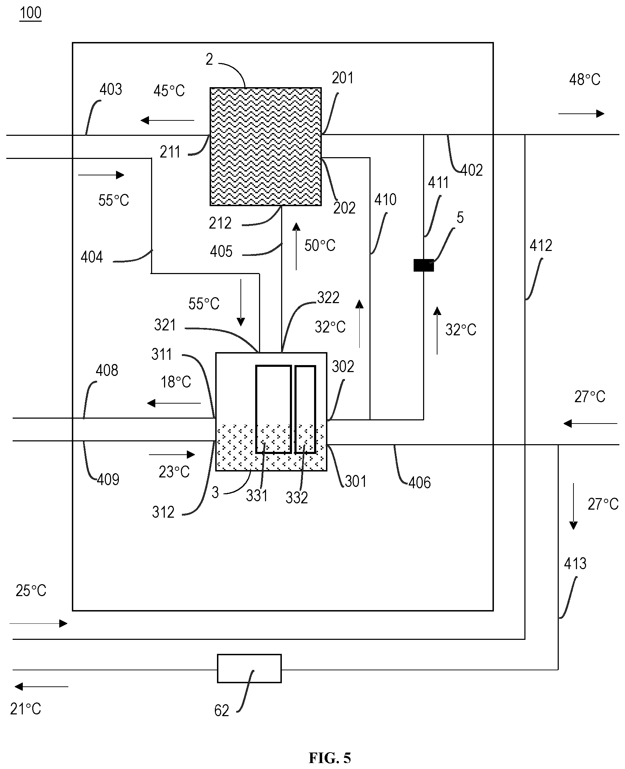

The liquid cooling proportion of the cooling system 100 will change due to the server type, load changes, etc. If the cooling system 100 cannot provide enough cooling amount to the air conditioning device, the cooling amount provided by the medium-temperature external cold source may be fully utilized and provided to the air conditioning device in a way of series supplementary cooling, so that the system has a certain design flexibility, and the adaptability of the solution to different types of liquid cooling parts is improved. Therefore, in some embodiments, as shown in Fig. 5, the pipeline 402 is also connected to the air conditioning device via a pipeline 412, the pipeline 406 is also connected to the air conditioning device via a pipeline 413, and the cooling system 100 further includes a second supplementary cooling unit 62 disposed in the pipeline 413. The second supplementary cooling unit 62 is connected between the pipeline 406 and the air conditioning device to cool the coolant from the medium-temperature external cold source. As an example, the temperature of the coolant from the medium-temperature external cold source is, for example, 27°C, the temperature of the coolant after supplementary cooling by the second supplementary cooling unit 62 is, for example, 21°C, and the temperature of the coolant returned from the air conditioning device to the pipeline 412 is, for example, 25°C.

Other structures of the cooling system 100 shown in Fig. 5 are similar to the structure of the cooling system 100 shown in Fig. 4, and will not be repeated here.

The embodiments of the present disclosure fully utilize the temperature gradient for cooling required by the cooling system 100, maximize the use of waste heat of the liquid cooling system, and combine the adsorption refrigeration technology to greatly raise the temperature of the external cold sources to medium temperature cold source or high temperature cold source, reduce energy consumption of the data center, and obtain lower power usage effectiveness (PUE) and water usage effectiveness (WUE). In addition, the cooling amount generated by adsorption refrigeration is very considerable, and in some working conditions, it may even exceed the cooling amount required by the air cooling side of the cooling system 100, and may provide cooling to other areas, thereby obtaining an extremely low PUE. In extreme cases, the PUE may even be lower than 1, thus transitioning from PUE to energy recovery efficiency (ERE). In addition, the cold sources of the liquid cooling side and the air cooling side are integrated to a certain extent, which reduces uncertainties in the preliminary planning process of the data center. At the same time, due to the effective use of the temperature gradient and the way of pooling the external cold source, this highly adaptable solution enables the data center to have excellent performance in energy saving and water saving in various forms.

The embodiments of the present disclosure are also reflected in the following examples.

Example 1. A cooling system for a data center, including: a heat exchanger, configured to cool a first secondary-side coolant and provide the cooled first secondary-side coolant to a device to be cooled; and an adsorption refrigeration assembly, connected to the heat exchanger and configured to: receive heated first secondary-side coolant from the device to be cooled, desorb at least one adsorption refrigeration module in the adsorption refrigeration assembly by using the heated first secondary-side coolant as a heat source, return the first secondary-side coolant to the heat exchanger, condense water vapor desorbed from the at least one adsorption refrigeration module into condensed water, and cool a second secondary-side coolant by using the condensed water and provide the cooled second secondary-side coolant to an air conditioning device.

Example 2. The cooling system of Example 1, where the heat exchanger includes a first cold source-side liquid supply port, a first cold source-side liquid return port, a first secondary-side liquid supply port, and a first secondary-side liquid return port, the first cold source-side liquid supply port is used to receive a first cold source-side coolant, the first cold source-side liquid return port is used to output the first cold source-side coolant, and the first secondary-side liquid supply port is used to be connected to the device to be cooled, so as to provide the cooled first secondary-side coolant to the device to be cooled; and the adsorption refrigeration assembly includes a second cold source-side liquid supply port, a second cold source-side liquid return port, a second secondary-side liquid supply port, a second secondary-side liquid return port, a first desorption connection port, and a second desorption connection port, the second cold source-side liquid supply port is used to receive a second cold source-side coolant, the second cold source-side liquid return port is used to output the second cold source-side coolant, the second secondary-side liquid supply port is used to provide the cooled second secondary-side coolant to the air conditioning device, the second secondary-side liquid return port is used to receive heated second secondary-side coolant from the air conditioning device, the first desorption connection port is used to receive the heated first secondary-side coolant from the device to be cooled and provide the first secondary-side coolant to the at least one adsorption refrigeration module, and the second desorption connection port is connected to the first secondary-side liquid return port of the heat exchanger, so as to return the first secondary-side coolant to the heat exchanger.

Example 3. The cooling system of Example 2, where the second cold source-side liquid supply port and the second cold source-side liquid return port are connected to a first external cold source to allow the second cold source-side coolant to circulate between the adsorption refrigeration assembly and the first external cold source; and the first cold source-side liquid supply port and the first cold source-side liquid return port are connected to a second external cold source to allow the first cold source-side coolant to circulate between the heat exchanger and the second external cold source, and a supply water temperature of the first external cold source is lower than a supply water temperature of the second external cold source.

Example 4. The cooling system of Example 2, where the second cold source-side liquid supply port and the first cold source-side liquid return port are connected to a first external cold source, the second cold source-side liquid return port is connected to the first cold source-side liquid supply port, the second cold source-side liquid supply port receives the second cold source-side coolant from the first external cold source, the second cold source-side liquid return port provides the second cold source-side coolant as the first cold source-side coolant to the first cold source-side liquid supply port, and the first cold source-side liquid return port returns the second cold source-side coolant to the first external cold source.

Example 5. The cooling system of Example 4 further includes a first supplementary cooling unit, connected between the first external cold source and the second cold source-side liquid supply port, to supplement cooling to the second cold source-side coolant.

Example 6. The cooling system of Example 4 further includes a bypass valve connected between the second cold source-side liquid return port and a first pipeline, the first pipeline being connected between the first cold source-side liquid return port and the first external cold source.

Example 7. The cooling system of Example 6, where the first pipeline is further connected to the air conditioning device, and the cooling system further includes a second supplementary cooling unit connected between a second pipeline and the air conditioning device, the second pipeline being connected between the second cold source-side liquid supply port and the first external cold source.

Example 8. The cooling system of any of Examples 2-7, where the adsorption refrigeration assembly includes a first adsorption refrigeration module and a second adsorption refrigeration module, and the first adsorption refrigeration module and the second adsorption refrigeration module are alternately connected to the first desorption connection port and the second desorption connection port, so as to be desorbed upon receiving the heated first secondary-side coolant and return the first secondary-side coolant to the heat exchanger.

Example 9. The cooling system of Example 8, where the adsorption refrigeration assembly further includes a steam condensation module, an evaporative refrigeration module, and a guide tube, the steam condensation module is used to condense the water vapor desorbed from the at least one adsorption refrigeration module into condensed water, the guide tube is used to guide the condensed water to the evaporative refrigeration module, and the evaporative refrigeration module is used to cool the second secondary-side coolant by using the condensed water and provide the cooled second secondary-side coolant to the air conditioning device.

Example 10. The cooling system of Example 9, where the first adsorption refrigeration module and the second adsorption refrigeration module alternately perform water absorption refrigeration to cool the second cold source-side coolant, and provide the cooled second cold source-side coolant to the steam condensation module to condense the water vapor desorbed from the at least one adsorption refrigeration module, and where the steam condensation module outputs the second cold source-side coolant via the second cold source-side liquid return port.

The embodiments of the present disclosure have been described above, and the above description is illustratively, not exhaustive, and is not limited to the disclosed embodiments. Many modifications and changes will be apparent to those of ordinary skill in the art without departing from the scope and spirit of the described embodiments. The choice of terms used herein is intended to best explain the principles, practical applications, or technical improvements to the market of the embodiments, or to enable other ordinary skilled persons in the art to understand the embodiments disclosed herein.

## Claims

1. A cooling system (100) for a data center, comprising:
a heat exchanger (2) configured to cool a first secondary-side coolant, and provide the cooled first secondary-side coolant to a device to be cooled; and
an adsorption refrigeration assembly (3) connected to the heat exchanger (2) and configured to: receive heated first secondary-side coolant from the device to be cooled, desorb at least one adsorption refrigeration module in the adsorption refrigeration assembly (3) by using the heated first secondary-side coolant as a heat source, return the first secondary-side coolant to the heat exchanger (2), condense water vapor desorbed from the at least one adsorption refrigeration module into condensed water, and cool a second secondary-side coolant by using the condensed water and provide the cooled second secondary-side coolant to an air conditioning device.

2. The cooling system (100) of claim 1, wherein the heat exchanger (2) comprises a first cold source-side liquid supply port (201), a first cold source-side liquid return port (202), a first secondary-side liquid supply port (211), and a first secondary-side liquid return port (212), the first cold source-side liquid supply port (201) is configured to receive a first cold source-side coolant, the first cold source-side liquid return port (202) is configured to output the first cold source-side coolant, and the first secondary-side liquid supply port (211) is configured to be connected to the device to be cooled, so as to provide the cooled first secondary-side coolant to the device to be cooled; and
the adsorption refrigeration assembly (3) comprises a second cold source-side liquid supply port (301), a second cold source-side liquid return port (302), a second secondary-side liquid supply port (311), a second secondary-side liquid return port (312), a first desorption connection port (321), and a second desorption connection port (322), the second cold source-side liquid supply port (301) is configured to receive a second cold source-side coolant, the second cold source-side liquid return port (302) is configured to output the second cold source-side coolant, the second secondary-side liquid supply port (311) is configured to provide the cooled second secondary-side coolant to the air conditioning device, the second secondary-side liquid return port (312) is configured to receive heated second secondary-side coolant from the air conditioning device, the first desorption connection port (321) is configured to receive the heated first secondary-side coolant from the device to be cooled and provide the first secondary-side coolant to the at least one adsorption refrigeration module, and the second desorption connection port (322) is connected to the first secondary-side liquid return port (212) of the heat exchanger (2), so as to return the first secondary-side coolant to the heat exchanger (2).

3. The cooling system (100) of claim 2, wherein the second cold source-side liquid supply port (301) and the second cold source-side liquid return port (302) are connected to a first external cold source to allow the second cold source-side coolant to circulate between the adsorption refrigeration assembly (3) and the first external cold source; and
wherein the first cold source-side liquid supply port (201) and the first cold source-side liquid return port (202) are connected to a second external cold source to allow the first cold source-side coolant to circulate between the heat exchanger (2) and the second external cold source, and a supply water temperature of the first external cold source is lower than a supply water temperature of the second external cold source.

4. The cooling system (100) of claim 2, wherein the second cold source-side liquid supply port (301) and the first cold source-side liquid return port (202) are connected to a first external cold source, the second cold source-side liquid return port (302) is connected to the first cold source-side liquid supply port (201), the second cold source-side liquid supply port (301) receives the second cold source-side coolant from the first external cold source, the second cold source-side liquid return port (302) provides the second cold source-side coolant as the first cold source-side coolant to the first cold source-side liquid supply port (201), and the first cold source-side liquid return port (202) returns the second cold source-side coolant to the first external cold source.

5. The cooling system (100) of claim 4, further comprising a first supplementary cooling unit (61) connected between the first external cold source and the second cold source-side liquid supply port (301), to supplement cooling to the second cold source-side coolant.

6. The cooling system (100) of claim 4, further comprising a bypass valve (5) connected between the second cold source-side liquid return port (302) and a first pipeline, the first pipeline being connected between the first cold source-side liquid return port (202) and the first external cold source.

7. The cooling system (100) of claim 6, wherein the first pipeline is further connected to the air conditioning device, and the cooling system (100) further comprises a second supplementary cooling unit (62) connected between a second pipeline and the air conditioning device, the second pipeline being connected between the second cold source-side liquid supply port (301) and the first external cold source.

8. The cooling system (100) of any of claims 2 to 7, wherein the adsorption refrigeration assembly (3) comprises a first adsorption refrigeration module (331) and a second adsorption refrigeration module (332), and the first adsorption refrigeration module (331) and the second adsorption refrigeration module (332) are alternately connected to the first desorption connection port (321) and the second desorption connection port (322), so as to be desorbed upon receiving the heated first secondary-side coolant and return the first secondary-side coolant to the heat exchanger (2).

9. The cooling system (100) of claim 8, wherein the adsorption refrigeration assembly (3) further comprises a steam condensation module (333), an evaporative refrigeration module (334), and a guide tube (335), the steam condensation module (333) is configured to condense the water vapor desorbed from the at least one adsorption refrigeration module into condensed water, the guide tube (335) is configured to guide the condensed water to the evaporative refrigeration module (334), and the evaporative refrigeration module (334) is configured to cool the second secondary-side coolant by using the condensed water and provide the cooled second secondary-side coolant to the air conditioning device.

10. The cooling system (100) of claim 9, wherein the first adsorption refrigeration module (331) and the second adsorption refrigeration module (332) alternately perform water absorption refrigeration to cool the second cold source-side coolant, and provide the cooled second cold source-side coolant to the steam condensation module (333) to condense the water vapor desorbed from the at least one adsorption refrigeration module, and wherein the steam condensation module (333) outputs the second cold source-side coolant via the second cold source-side liquid return port (302).
